# EUROPÄISCHE PATENTSCHRIFT

(11) **EP 1 145 025 B1**
(45) Veröffentlichungstag und Bekanntmachung des Hinweises auf die Patenterteilung: **07.05.2003**
(21) Anmeldenummer: 99964589.8
(22) Anmeldetag: 17.12.1999
(51) Int. Cl.: G01R 33/038

(54) **KAPAZITIVER MAGNETFELDSENSOR**
CAPACITIVE MAGNETIC FIELD SENSOR
DETECTEUR DE CHAMP MAGNETIQUE CAPACITIF

(30) Priorität: 19.12.1998 DE 19858826
(43) Veröffentlichungstag der Anmeldung: 17.10.2001
(73) Patentinhaber: Micronas GmbH, 79108 Freiburg (DE)
(72) Erfinder: IGEL, Günter, D-79331 Teningen (DE); SIEBEN, Ulrich, D-79276 Reute (DE); GIEHL, Jürgen, D-79199 Kirchzarten (DE)
(74) Vertreter: Patentanwälte Westphal, Mussgnug & Partner
(86) Internationale Anmeldenummer: EP9910045
(87) Internationale Veröffentlichungsnummer: WO00037954

(56) Entgegenhaltungen:
- US-A- 5 036 286
- US-A- 5 639 973
- AYELA F ET AL: "A micromachined silicon magnetometer" SENSORS AND ACTUATORS A,CH,ELSEVIER SEQUOIA S.A., LAUSANNE, Bd. 61, Nr. 1-3, 1. Juni 1997 (1997-06-01), Seiten 339-341, XP004092245 ISSN: 0924-4247

## Beschreibung

Es sind eine Vielzahl von Magnetfeldsensoren bekannt, die auf den Hall- oder den magnetoresistiven Effekt zurückgreifen. Diese Magnetfeldsensoren zeigen eine extreme Temperaturabhängigkeit, weshalb sie für hochgenaue Anwendungsbereiche entweder wenig geeignet sind oder sehr aufwendige elektronische oder elektrische Temperaturkorrekturen erforderlich machen.

Weiterhin sind kapazitive Sensoren zur Messung von Drücken oder Beschleunigungen gebräuchlich. Sie erweisen sich regelmäßig als mechanisch sehr stabil und von sehr geringen Ausmaßen.

Einen kapazitiven Magnetfeldsensor mit einer membran förmigen Electrode offenbart die Patentschrift US 5,639,973 A.

Der Erfindung liegt die Aufgabe zugrunde, einen Magnetfeldsensor zu schaffen, welcher weniger von störenden Temperatureffekten abhängig ist.

Diese Aufgabe wird erfindungsgemäß durch die im Anspruch 1 angegebenen Merkmale gelöst.

Der erfindungsgemäße kapazitive Magnetfeldsensor zeigt zwei Elektroden, welche voneinander beabstandet sind und eine Messkapazität bilden. Dabei ist die erste Elektrode auf einem ersten Substratkörper und die zweite Elektrode auf einem zweiten Substratkörper angeordnet, wobei der zweite Substratkörper im Bereich der zweiten Elektrode als verformbare Membran ausgebildet ist und einen magnetischen Körper aufweist, der mit der Membran und der zweiten Elektrode starr verbunden ist. Wird der magnetische Körper durch ein äußeres Magnetfeld in eine geänderte Lage verbracht, so wird diese Lageveränderung über die starre Verbindung zwischen dem magnetischen Körper, der Membran und der zweiten Elektrode auf diese zweite Elektrode übertragen und dadurch der Abstand zwischen den beiden Elektroden verändert, so dass sich die Messkapazität des Sensors abhängig vom äußeren Magnetfeld verändert. Damit ist eine sichere Messung der Magnetfeldstärke über die Veränderung der kapazitiven Eigenschaften des Sensors gegeben. Durch diese Art des Aufbaus des Magnetfeldsensors gelingt es, die Temperaturabhängigkeit wesentlich zu reduzieren, da hier die elastischen Eigenschaften des kapazitiven Sensors wesentlich geringeren Temperaturabhängigkeiten unterliegen als die aus dem Stand der Technik bekannten Hall- oder magnetoresistiven Effekte. Weiterhin erweist sich der erfindungsgemäße kapazitive Magnetfeldsensor sowohl als mechanisch sehr stabil und wenig anfällig als auch von sehr geringen räumlichen Ausmaßen.

Vorteilhafte Ausführungen des kapazitiven Magnetfeldsensors sind in den Unteransprüchen dargestellt. Insbesondere erweist es sich als besonders vorteilhaft, die zweite Elektrode und die magnetischen Körper auf verschiedenen Seiten der Membran anzuordnen, wodurch eine mechanische oder elektrische direkte Beeinflussung des magnetischen Körpers durch die zweite Elektrode aufgrund der sie trennende Membran ausgeschlossen ist. Ebenso erweist sich durch diese vorteilhafte Anordnung auch die Herstellung des Sensors als wesentlich einfacher, da beide Seiten der Membran unterschiedlichen Fertigungsprozessen unterliegen können, die sich durch die mechanische Trennung mittels der Membran wechselseitig nicht beeinflussen oder stören können.

Damit gelingt es, den Fertigungsprozess des kapazitiven Magnetfeldsensors zu vereinfachen und kostengünstig zu gestalten.

Erfindungsgemäß ist der magnetische Körper als dünne, plane, Schicht aufgebaut, welche flächig mit der Membran verbunden ist. Durch diese flächige Verbindung entsteht eine sehr steife Anordnung aus einem schichtförmigen magnetischen Körper, Membran und zweite Elektrode, wodurch die mechanische Temperaturabhängigkeit der Eigenschaften des kapazitiven Sensors durch den starren Aufbau der verschiedenen Materialien deutlich verringert ist. Weiterhin läßt sich diese Schicht sehr einfach in der Art eines elektrochemischen Depositionsprozesses, vergleichbar dem Prozess zur Aufbringung von Leiterbahnen auf Leiterplatten, aufbringen, was eine definierte Schichtstärke auf einfache Weise ermöglicht. Damit ist gewährleistet, dass eine definierte Menge an magnetischem Material für den magnetischen Körper verwendet wird, der ausreicht, eine deutliche und damit ausreichende Beeinflussung der Lage des magnetischen Körpers durch ein externes Magnetfeld zu bewirken und dadurch die Magnetfeldstärke zu bestimmen. Als besonders vorteilhaft hat sich dabei die Verwendung von ferromagnetischem Material herausgestellt, das durch eine entsprechene Auslegung der Dispositionsverfahren auf sehr einfache und sichere Art aufgebracht werden kann.

Nach einer bevorzugten Ausführungsform des kapazitiven Magnetfeldsensors ist in wenigstens einem der Substratkörper eine elektronische Anordnung zur Verarbeitung der Messsignale integriert. Diese Integration erfolgt in der Art eines integrierten Schaltkreises. Damit ist gewährleistet, dass neben dem extrem kompakten Aufbau des kapazitiven Sensors mit der Anordnung zur Auswertung der Messsignale auch eine elektronisch sehr vorteilhafte Anordnung gegeben ist, die sich insbesondere durch geringe Verlustleistungen auf dem Weg vom eigentlichen kapazitiven Magnetfeldsensor zu der Anordnung zur Verarbeitung der Messsignale auszeichnet und dadurch auch ein besonders gutes Signalrauschverhältnis zeigt und dadurch eine sehr differenzierte Auswertung und Darstellung der Magnetfeldstärke ermöglicht. Mithin erweist sich dieser erfindungsgemäße kapazitive Magnetfeldsensor als überaus kompakter und sehr hochauflösender sicherer Magnetfeldsensor. Derartige Sensoren sind insbesondere in der Automobilindustrie von besonderer Bedeutung, wo regelmäßig nur ein sehr begrenztes Raumangebot zur Verfügung steht.

Vorzugsweise wird die elektronische Anordnung zur Verarbeitung der Messsignale in dem ersten Substratkörper unterhalb der darauf angebrachten Elektrode angeordnet. Dieser Aufbau in dem mechanisch steifen, nicht beweglichen ersten Substratkörper gewährleistet auch eine mechanisch wenig anfällige elektronische Anordnung zur Verarbeitung der Messsignale, was den Einsatzbereich dieses kapazitiven Magnetfeldsensors wesentlich erweitert und ihn insbesondere für die Automobilindustrie oder Luftfahrtindustrie tauglich macht.

Als besonders vorteilhaft hat sich herausgestellt, die elektronische Anordnung zur Verarbeitung der Messsignale aufzuteilen und getrennt in die zwei verschiedenen Substratkörper anzuordnen. Auch hier wird die elektronische Anordnung vorzugsweise in der Art eines integrierten Schaltkreises ausgebildet. Durch diese Aufteilung lassen sich elektronische Funktionsgruppen wie Verstärkeranordnung, Auswertungseinheiten oder Steuerungseinheiten voneinander elektronisch entkoppeln und dadurch ein Übersprechen von der einen Funktionsgruppe in die andere Funktionsgruppe verhindern. Damit lassen sich gerade im Fall von sehr schwachen Signalen mit insbesondere schlechtem Signalrauschverhältnis dennoch sehr aussagekräftige Messergebnisse für die Feldstärke berechnen und darstellen, da nun eine Verschlechterung der Messergebnisse aufgrund eines Übersprechens bei der Verstärkung, der Auswertung u.s.w. durch diese Anordnung zur Verarbeitung der Messsignale deutlich reduziert sind.

Als besonders geeignet hat sich herausgestellt, den kapazitiven Magnetfeldsensor so auszubilden, dass wenigstens eine der Elektroden durch Leiterbahnen auf dem jeweiligen Substrat ausgebildet sind, die vorzugsweise Teil der elektronischen Anordnung zur Verarbeitung der Messsignale sind. Durch diese Ausbildung lassen sich die Elektroden sehr einfach herstellen und in ihrer Form und Ausmaß den jeweiligen Bedürfnissen spezifisch anpassen, wodurch eine den jeweiligen Bedürfnissen angepasster, sehr kompakter, sehr sicher funktionierender und aussagekräftiger kapazitiver Magnetfeldsensor gegeben ist. Insbesondere gelingt es auch gerade bei der Benutzung der Leiterbahn der elektronischen Anordnung einerseits als Elektrode und andererseits als elektronisches Element der Anordnung eine sehr hohe Integration der Gesamtanordnung zu schaffen und diese Leiterbahn synergetisch zu nutzen.

Ein besonders vorteilhafter kapazitiver Magnetfeldsensor, der aber nicht beansprucht wird, zeigt eine Elektrode, die durch eine räumliche Strukturierung in der Lage ist, die räumliche Zuordnung der Elektroden zueinander über den reinen Abstand hinaus weitergehend räumlich aufzulösen. Dadurch gelingt es neben der reinen Darstellung der Magnetfeldstärke auch die Orientierung des Magnetfeldes oder die zeitliche bzw. räumliche Veränderung des Magnetfeldes durch die ortsauflösende Messung darzustellen und dem Benutzer zur Verfügung zu stellen. Dieser Aspekt kommt insbesondere dann zum Tragen, wenn die beiden Elektroden durch einen äußeren Einfluss, z. B. Verlauf des Magnetfeldes oder zeitliche bzw. räumliche Veränderung des Magnetfeldes, nicht parallel zueinander angeordnet sind, sondern in einem Winkel zueinander stehen und dieser sich durch die flexible Ausbildung der Membran verändert und/oder die Elektroden zueinander verschoben werden. Derartige Veränderungen erweisen sich für den Benutzer des kapazitiven Magnetfeldsensors als sehr nützlich, da er eine weitere Information über das zeitliche bzw. räumliche Verhalten des externen Magnetfeldes erhält. Derartige Aussagen lassen insbesondere Schlüsse auf die weitere Ansteuerung und/oder Verstärkung der Messsignale zu. Als besonders vorteilhaft hat sich herausgestellt, die elektronische Anordnung zur ortsauflösenden Verarbeitung der Messsignale der räumlich strukturierten Elektrode entsprechend der elektronischen Anordnung zur Verarbeitung der Messsignale in einer oder in beiden Substraten anzuordnen. Auch hier erweist sich diese nicht beanspruchte Anordnung als sowohl fertigungstechnisch als auch im Hinblick auf die Kompaktheit des kapazitiven Magnetfeldsensors wie auch auf dessen mechanische Stabilität als besonders vorteilhaft.

Ein Ausführungsbeispiel der Erfindung ist in der Zeichnung dargestellt und wird im Folgenden näher beschrieben.

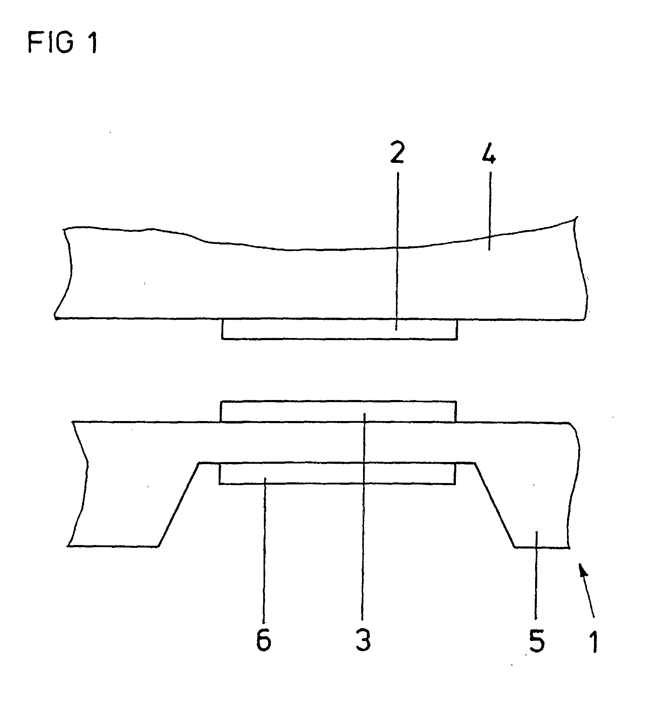

In Figur 1 schematischer Aufbau des kapazitiven Magnetfeldsensors 1 gezeigt. Der kapazitive Magnetfeldsensor 1 zeigt eine erste Elektrode 2, die auf einem ersten Substratkörper 4 angeordnet ist. Der ersten Elektrode 2 ist eine zweite Elektrode 3 zugeordnet, die von dieser beabstandet angeordnet ist und auf einem zweiten Substratkörper 5 angebracht ist. Der zweite Substratkörper 2 ist im Bereich der zweiten Elektrode 3 als Membran ausgebildet. Dadurch kann sich der Abstand zwischen den beiden Elektroden 2 und 3 abhängig von der Art und damit von der Härte der Membran bei Einwirkung einer Kraft auf die Membran mehr oder weniger stark aneinander annähern oder voneinander entfernen. Bei dem kapazitiven Magnetfeldsensorl ist auf der Rückseite der Membran, also auf der der zweiten Elektrode 3 abgewandten Seite, ein magnetischer Körper 6 angeordnet, der abhängig von einem äußeren Magnetfeld eine definierte Kraft auf die Membran bringt und dadurch die Membran mit der zweiten Elektrode 3 auslenkt und dadurch den Abstand zwischen den beiden Elektroden 2 und 3 verändert. Diese Abstandsänderung bewirkt eine Änderung der Kapazität der Anordnung aus den beiden Elektroden 2 und 3, die durch eine hier nicht dargestellte Anordnung zur Verarbeitung der Messsignale in dem ersten Substrat 4 verstärkt und ausgewertet wird. Damit ist eine Möglichkeit geschaffen, die Feldstärke des externen Magnetfeldes über die besondere Ausbildung des kapazitiven Magnetfeldsensors sehr sicher zu messen, ohne dass starke Temperaturabhängigkeiten durch das erfindungsgemäß realisierte Konzept des Magnetfeldsensors zum Tragen kommt.

### Bezugszeichenliste

- 1: Kapazitiver Magnetfeldsensor
- 2: erste Elektrode
- 3: zweite Elektrode
- 4: erster Substratkörper
- 5: zweiter Substratkörper
- 6: magnetischer Körper

## Patentansprüche

1. Magnetfeldsensor (1) mit einer ersten Elektrode (2) und einer zweiten Elektrode (3), welche von einander beabstandet sind und eine Messkapazität bilden, wobei die erste Elektrode (2) auf einem ersten Substratkörper (4) und eine zweite Elektrode (3) auf einem zweiten Substratkörper (5) angeordnet sind und der zweite Substratkörper (5) im Bereich der zweiten Elektrode (3) als verformbare Membran ausgebildet ist, wobei ein magnetischer Körper (6) mit der Membran und der zweiten Elektrode (3) so verbunden ist, dass eine durch ein äußeres Magnetfeld induzierte Lageveränderung des magnetischen Körpers (6) zu einer Lageveränderung der zweiten Elektrode (3) über die Membran und diese zu einer Kapazitätsänderung führt,
**dadurch gekennzeichnet,**
**dass** der magnetische Körper (6) als auf die Membran flächig aufgebrachte, plane Schicht ausgebildet ist.

2. Magnetfeldsensor nach Anspruch 1,
**dadurch gekennzeichnet, dass** die zweite Elektrode (3) und die magnetische Schicht (6) auf gegenüberliegenden Seiten der Membran angeordnet sind.

3. Magnetfeldsensor nach einem der vorstehenden Ansprüche,
**dadurch gekennzeichnet, dass** der magnetische Körper (6) ferromagnetisches Material aufweist.

4. Magnetfeldsensor nach einem der vorangegangenen Ansprüche, **dadurch gekennzeichnet, dass** in wenigstens einem der Substratkörper (4, 5) eine elektronische Anordnung zur Verarbeitung von von der Messkapazität abgeleiteten Messsignalen integriert ist.

5. Magnetfeldsensor nach Anspruch 4,
**dadurch gekennzeichnet, dass** die elektronische Anordnung zur Verarbeitung der Messsignale in dem ersten Substratkörper (4) angeordnet ist.

6. Magnetfeldsensor nach Anspruch 4,
**dadurch gekennzeichnet, dass** ein erster Teil der elektronischen Anordnung zur Verarbeitung der Messsignale in dem ersten Substratkörper (4) und ein zweiter Teil der elektronischen Anordnung zur Verarbeitung der Messsignale in dem zweiten Substratkörper (5) angeordnet ist.

7. Magnetfeldsensor nach einem der Ansprüche 4 bis 6,
**dadurch gekennzeichnet, dass** die elektronische Anordnung zur Verarbeitung der Messsignale signalverstärkende Elemente aufweist.

8. Magnetfeldsensor nach einem der Ansprüche 4 bis 7,
**dadurch gekennzeichnet, dass** wenigstens eine der Elektroden aus einer oder mehreren Leiterbahnen gebildet ist.

9. Magnetfeldsensor nach Anspruch 8,
**dadurch gekennzeichnet, dass** die Leiterbahn Teil der elektronischen Anordnung zur Verarbeitung der Messsignale ist.

10. Kapazitiver Sensor nach Anspruch 9,
**dadurch gekennzeichnet, dass** die Elektrode (2, 3) zueinander parallel angeordnete, streifenförmige Elemente aufweist.

## Claims

1. A magnetic field sensor (1) having a first electrode (2) and a second electrode (3), which are spaced from one another and form a measuring capacitance, with the first electrode (1) being disposed on a first substrate member (4) and a second electrode (3) being disposed on a second substrate member (5) and the second substrate member (5) being constructed as a deformable membrane in the region of the second electrode (2), with a magnetic body (6) being connected to the membrane and the second electrode (3) so that a change in position of the magnetic body (6) induced by an external magnetic field results in a change in position of the second electrode (3) via the membrane and this results in a change in capacitance,
**characterised in that** the magnetic body (6) is constructed as a plane layer applied flat to the membrane.

2. A magnetic field sensor according to Claim 1,
**characterised in that** the second electrode (3) and the magnetic layer (6) are disposed on opposite sides of the membrane.

3. A magnetic field sensor according to one of the preceding Claims,
**characterised in that** the magnetic member (6) is made from ferromagnetic material.

4. A magnetic field sensor according to one of the preceding Claims,
**characterised in that** an electronic configuration for processing measuring signals derived from the measuring capacitance is integrated in at least one substrate member (4, 5).

5. A magnetic field sensor according to Claim 4,
**characterised in that** the electronic configuration for processing the measuring signals is disposed in the first substrate member (4).

6. A magnetic field sensor according to Claim 4,
**characterised in that** a first part of the electronic configuration for processing the measuring signals is disposed in the first substrate member (4) and a second part of the electronic configuration for processing the measuring signals is disposed in the second substrate member (5).

7. A magnetic field sensor according to one of Claims 4 to 6,
**characterised in that** the electronic configuration for processing the measuring signals comprises signal-amplifying elements.

8. A magnetic field sensor according to one of Claims 4 to 7,
**characterised in that** at least one of the electrodes is made from one or more track conductors.

9. A magnetic field sensor according to Claim 8,
**characterised in that** the track conductor is part of the electronic configuration for processing the measuring signals.

10. A capacitive sensor according to Claim 9,
**characterised in that** the electrode (2, 3) comprises strip-shaped elements disposed mutually parallel,

## Revendications

1. Capteur de champ magnétique (1) comportant une premiére électrode (2) et une seconde électrode (3) distante l'une de l'autre et formant une capacité de mesure, la première électrode (2) étant réalisée sur un premier substrat (4) et la seconde électrode (3) sur un second substrat (5) réalisé au niveau de la seconde électrode (3) comme membrane déformable.
un corps magnétique (6) relié à la membrane et à la seconde électrode (3) pour qu'une variation de position du corps magnétique (6), induite par un champ magnétique extérieur conduit à une variation de position de la seconde électrode (3) par la membrane et à une variation de capacité,
**caractérisé en ce que**
le corps magnétique (6) est réalisé sous la forme d'une couche plane appliquée en surface sur la membrane.

2. Capteur de champ magnétique selon la revendication 1,
**caractérisé en ce que**
la seconde électrode (3) et la couche magnétique (6) sont prévues sur les côtés opposés de la membrane.

3. Capteur de champ magnétique selon l'une des revendications précédentes,
**caractérisé en ce que**
le corps magnétique (6) est en matière ferromagnétique.

4. Capteur de champ magnétique selon l'une des revendications précédentes.
**caractérisé en ce qu'**
au moins un dispositif de traitement de signaux de mesure déduits de la capacité est intégré à au moins l'un des substrats (4, 5).

5. Capteur de champ magnétique selon la revendication 4,
**caractérisé en ce que**
le dispositif électronique de traitement des signaux de mesure est prévu dans le premier substrat (4).

6. Capteur de champ magnétique selon la revendication 4,
**caractérisé en ce qu'**
une première partie du dispositif électronique pour traiter les signaux de mesure est prévue dans le premier substrat (4) et une seconde partie du dispositif électronique de traitement des signaux de mesure est prévue dans le second substrat (5).

7. Capteur de champ magnétique selon l'une des revendications 4 à 6,
**caractérisé en ce que**
le dispositif électronique de traitement des signaux de mesure comporte des éléments amplificateurs de signal.

8. Capteur de champ magnétique selon l'une des revendications 4 à 7,
**caractérisé en ce qu'**
au moins l'une des électrodes est formée par un ou plusieurs chemins conducteurs.

9. Capteur de champ magnétique selon la revendication 8,
**caractérisé en ce que**
le chemin conducteur fait partie du dispositif électronique de traitement des signaux de mesure.

10. Capteur de champ magnétique selon la revendication 9,
**caractérisé en ce que**
les électrodes (2, 3) sont des éléments en forme de bande, parallèles.
